Europäisches Patentamt

European Patent Office

Office européen des brevets

(19)

(11) **EP 1 182 274 A1**

(12) **EUROPÄISCHE PATENTANMELDUNG**

(43) Veröffentlichungstag:
   **27.02.2002 Patentblatt 2002/09**

(51) Int Cl.$^7$: **C23C 16/26**, C23C 16/27

(21) Anmeldenummer: **01120344.5**

(22) Anmeldetag: **24.08.2001**

(84) Benannte Vertragsstaaten:
   **AT BE CH CY DE DK ES FI FR GB GR IE IT LI LU MC NL PT SE TR**
   Benannte Erstreckungsstaaten:
   **AL LT LV MK RO SI**

(30) Priorität: **26.08.2000 DE 10042099**

(71) Anmelder: **PlasmOTec GmbH & Co. KG**
   **53619 Rheinbreitbach (DE)**

(72) Erfinder:
   • **Musche, Stefan M.**
    **47506 Neukirchen-Vluyn (DE)**
   • **Hufschmied, Ralph Rudolf**
    **86179 Augsburg (DE)**

(74) Vertreter: **Müller-Wolff, Thomas, Dipl.-Ing. et al**
   **HARWARDT NEUMANN Patent- und**
   **Rechtsanwälte, Brandstrasse 10**
   **53721 Siegburg (DE)**

(54) **Diamantbeschichtetes Hartmetall-Schneidwerkzeug und Verfahren zu seiner Herstellung**

(57)    Die Erfindung betrifft ein diamantbeschichtetes Hartmetall-Schneidwerkzeug, bestehend aus einer auf einem Substrat aufgetragenen Diamantschicht (2), die ein geschlossenes Grundprofil bildet, und einer darauf abgeschiedenen Kohlenstoffschicht (3). Die Diamantschicht ist polykristallin, wobei die Diamantkristalle statistisch orientiert sind. Die Kohlenstoffschicht weist eine amorphe Struktur mit einem Anteil an kovalenten sp3-Bindungen der Kohlenstoffatome von weniger als 70% auf. Zur Herstellung wird der Hartmetallgrundkörper mit einer kristallinen Diamantschicht im CVD-Verfahren bei Temperaturen über 800°C beschichtet, dann ein PVD-Re-Sputtern der über das Grundprofil hinausragenden Diamantkristalle mit einer Änderung der SP3-Diamantbeschichtung zu SP2-Doppelbindungen vorgenommen und danach eine Kohlenstoffbeschichtung im PVD-Verfahren bei einer Temperatur von weniger als 500°C durchgeführt, wobei die Kohlenstoffschicht durch Zugabe eines Reaktivgases in einer amorphen Struktur ausgebildet wird.

Fig. 2

Keramikgrundkörper

Beschichtungsverfahren

CVD-Technik → Temperatur : > 800°C

Reaktionsgase:
Azetylen
Wasserstoff
Methan

Kristalline Diamantschicht

Re-Sputtern mit
PVD-Technik →
HF-Plasma mit Argon als Prozessgas
HF-Leistung: 1000W
Temperatur : 360°C
Druck      : 270mPa
Dauer      : 2400s
Temperatur : 300 – 500°C

Umformen der SP3-
Kohlenstoffbindung in
SP2-Doppelbindung
Zeitdauer =    60 min

PVD-Sputtern Temp 250-300°C
600 mpascal Druck
2 x 8 KW Grafittargets
Energie
N$_2$ 75-90mln
Ar 250mln

Amorphe
Graphit/Kohlenstoffgleit-
schicht

3 Schichten aus kristalliner
amorpher Struktur

EP 1 182 274 A1

## Beschreibung

Die Erfindung betrifft ein diamantbeschichtetes Hartmetall-Schneidwerkzeug, bestehend aus einer auf einem Substrat aufgetragenen Diamantschicht, die ein geschlossenes Grundprofil bildet, und einer darauf abgeschiedenen Kohlenstoffschicht sowie ein Verfahren zur Herstellung eines Hartmetallwerkzeuges.

Aus der DE-PS 36 08 734 ist ein Schneidwerkzeug zur spanabhebenden Bearbeitung bekannt, bestehend aus einem Grundkörper oder Substrat aus gesinterten keramischen Werkstoffen, einer Zwischenschicht aus Siliziumdioxid und einer Nutzschicht aus Hartmetallkarbiden oder -nitriden, wie z.B. Titankarbid, Titannitrid, Niob, Borid und Siliziumkarbid.

Für den Einsatzbereich zum Zerspanen von Graphit- oder keramischen Grünlingskörpern, die eine sehr hohe Härte aufweisen, sind die bekannten Schneidwerkzeuge der eingangs genannten Art nicht geeignet. Hierfür wurden Schneidwerkzeuge mit Diamantbeschichtung entwickelt, die überwiegend im CVD-Verfahren aufgetragen wird.

Wie aus der DE-OS 198 25 983 bekannt ist, lässt sich durch das Aufbringen einer Diamant- und karbidischen Phasen enthaltenden Komposit-Gradientenschicht im CVD-Verfahren verhindern, dass Abplatzungen der Schicht vom Substrat auftreten, was auf extrem hohe thermische Druckspannungen in den Diamantschichten bei der Abkühlung von der Beschichtungstemperatur zurückzuführen ist. Anwendungsrelevante Eigenschaften wie z.B. die Verschleißbeständigkeit etc. werden in dieser Veröffentlichung nicht verbessert.

Wegen der stark abrasiven Beanspruchung bei der Grünlingsbearbeitung sind den Kompositschichten jedoch reine Diamantschichten aufgrund der höheren Härte vorzuziehen. Allerdings wirken neben den (111)-Spaltebenen des Diamantgitters noch die Korngrenzen, die in den kristallinen Schichten zwangsläufig vorhanden sind, als Schwachpunkte bei äußerer Stoß- bzw. Schlagbelastung. Es kommt zu Rissbildung beim Aufprall der harten, aus den Grünlingen herausgelösten Pulverpartikeln und im weiteren Verlauf brechen die Korngrenzen auf, so dass einzelne Diamantkristalle aus der Diamantschicht herausgeschlagen werden. Da die Größe der Diamantkristalle bis 1/3 oder ½ der gesamten Schichtdicke betragen kann, führt dies zu einer relativ hohen Abtragsrate der Diamantschicht.

Es ist möglich, den Verschleiß durch amorphe Deckschichten ohne Korngrenzen zu reduzieren. Denkbar wäre die Abscheidung von DLC-Schichten, die wegen ihrer im Vergleich zum Diamant extrem niedrigen Härte nicht fest auf den Diamantschichten haften, was insbesondere bei der Trockenbearbeitung von Grünlingskörpern zu einem frühzeitigen Totalausfall des Werkzeuges führt.

Aus DE 198 50 346 A1 ist eine Diamantschicht mit (100)-Textur und definiert einstellbarer Oberflächenrauhigkeit bekannt, wobei in die Vertiefungen an der rauen Oberfläche ein zusätzliches Material, z.B. eine DLC-Schicht eingebracht wird. Bei der bekannten Diamantschicht mit 100-Textur liegt ein Gegenkörper durchgängig auf einer ebenen Fläche auf, wobei alle oder nur ein Teil der Vertiefungen ganz oder teilweise ausgefüllt sein können. Die Diamantschicht wird zweistufig mittels CVDVerfahren hergestellt, wobei dem Reaktionsgas für das selektive Aufwachsen in 100-Orientierung in der ersten Stufe geringe Mengen an Stickstoff zugesetzt werden.

Aus DE 4142202 A1 ist ein magnetisches Bauteil bekannt, das eine nicht geschlossene kristalline Diamantschicht mit einer darauf befindlichen Schicht aus amorphem Kohlenstoff bei einer Gesamtschichtdicke von < 100nm aufweist. Die Herstellung der kristallinen Diamantschicht erfolgt mittels CVD-, die der amorphen Kohlenstoffschicht mittels CVD- oder PVD-Verfahren. Der amorphe Kohlenstoff füllt lediglich die Lücken zwischen den Diamantinseln aus, um die Ablagerung von Staub oder Chemikalien zu verhindern.

Aufgabe der vorliegenden Erfindung ist es, die bei der spanenden Trocken-Bearbeitung von Graphit- und Grünlingskörpern mit diamantbeschichteten Hartmetallschneidwerkzeug auftretenden Verschleißprobleme, die sich infolge der beim Bearbeiten entstehenden, harten und stark abrasiv wirkenden Partikel bzw. Stäube ergeben, zu vermeiden. Konkret soll die Verschleißrate der Diamantschicht verringert und die Standzeit insbesondere durch eine Reduzierung des Anfangsverschleißes an den Schneid- und den Nebenschneidflächen von Spanwerkzeugen, erhöht werden. Ferner soll die Werkzeugoberfläche durch eine elastische Abstützung der Diamantoberfläche vor mechanischen Abrasionserscheinungen geschützt sowie die Spanabfuhr verbessert werden.

Diese Aufgabe wird durch die in den Patentansprüchen angegebenen Merkmale gelöst. Es hat sich gezeigt, dass die chemische Einlagerung von elastischen Kohlenstoffschichten in die Zwischenräume der kristallinen Diamantoberfläche zu einem verbesserten Verschleißverhalten führt, wobei die Delamination am Interface von Diamant- und Kohlenstoffschicht durch eine zusätzliche Chemiesorptionsschicht, die einen zäheren Übergang bildet, verhindert wird. Darüber hinaus wird ein Verhaken der pulvrigen Partikel in der Diamantschicht bzw. ein Aufstau in der Spannut vermieden, so dass eine hohe Einsatzzeit des neuen Spanwerkzeuges erreicht wird.

Zur Definition der sp3- und sp2-Schichten wird auf H.Haken und H.C. Wolf "Atom- und Quantenphysik", 3. Auflage S.416-419 verwiesen. Im Prinzip handelt es sich um einen "Re-Sputtervorgang", bei dem C-Atome aus der Randzone der Diamantschicht herausgelöst werden, so dass aus der dreidimensionalen sp3-Anordnung in Pyramidenform eine zweidimensionale sp2-Schicht entsteht. Die Änderung des Schichtaufbaus kann durch verschiedene Verfahren sichtbar gemacht werden, z.B. mit der RAMAN-Spektroskopie.

Im folgenden wird die Erfindung anhand mehrerer Ausführungsbeispiele nähre erläutert. Es zeigen:

Fig. 1    Prinzipieller Aufbau eines erfindungsgemäß ausgebildeten Spanwerkzeuges;

Fig. 2    Blockschaltbild der erfindungsgemäßen Herstellungsweise.

Fig. 3    Reaktionsbedingung für die Herstellung elastischer CSchichtstrukturen

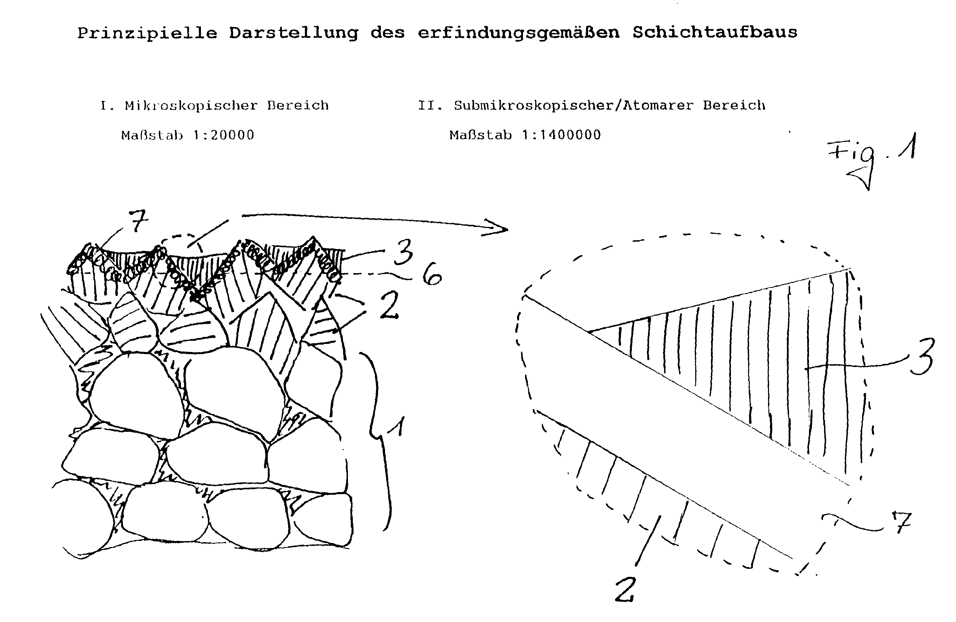

In Figur 1 ist ein keramischer Hartmetallgrundkörper 1 darstellt, der aus verschiedenen Materialien bestehen kann. Beispielsweise kann der Grundkörper aus Karbikeramik-Werkstoffen wie Wolframcarbid und Titancarbid mit je 5 - 10 % Kobalt hergestellt werden.

Auf dem Grundkörper 1 befindet sich eine polykristalline Diamantschicht 2, die durch CVD-Beschichtung aufgetragen wurde. An der vom Hartmetallgrundkörper abgewandten Seite ist die Schicht scharfkantig und weist statistisch orientierte, freiliegende Kristallflächen 4 und Zwischenräume 5 auf.

Die Randzone der obersten Kristalle der Diamantschicht wird durch einen besonderen Re-Sputter-Vorgang so umgebildet, dass dort der Kohlenstoff anstelle in den ehemaligen sp3-Diamantbindungen in sp2-Bindungen vorliegt. In die Oberfläche der Diamantkristalle wächst somit eine hauchdünne Chemiesorptionsschicht als Haftgrundlage für die anschließende Beschichtung mit einer elastischen Kohlenstoffschicht ein, die ebenfalls graphitähnliche sp2-Kohlenstoffbindungsanteile und diamantähnliche sp3-Bindungsanteile enthält.

Im Anschluss an das Re-Sputtern wird in die Zwischenräume 5 der kristallinen Diamantschicht 2 mit sp2-gebundenem Kohlenstoff an der Oberfläche eine Schicht aus amorphen graphit- und diamantähnlichem Kohlenstoff 3 im PVD-Verfahren aufgebracht. Die Struktur ist der bekannten amorphen Kohlenstoffschicht nachgebildet, allerdings mit mehrlagigem Aufbau durch ein wechselndes Verhältnis der Bindungsanteile der weicheren sp2-zur härteren sp3-Bindung zwischen 1:2 und 2:1. Dies resultiert in einem Abbau von Eigenspannungen in der Schicht, so dass sie eine im Vergleich zur Mikrohärte des Diamants (8-10.000 HV) verringerte Mikrohärte von 1 bis 2.000 HV bei wesentlich höheren Zähigkeitswerten des Mehrschichtverbundes aufweist.

Die Kohlenstoffschicht hat wegen ihrer amorphen Struktur mit freiem formbarem Volumen und der Mehrlagigkeit dämpfende Eigenschaften und befindet sich in den Zwischenräumen 5 zwischen den einzelnen Diamantkristallen der Diamantschicht 2. Sie nimmt die Aufprallenergie der pulverförmigen Späne oder Hartstoffpartikel auf und ermöglicht einen Schutz der Kristallflächen 4 vor mechanischer Abrasion. Ein zweiter Vorteil ist der ungehinderte Spanabfluß in den Spannuten.

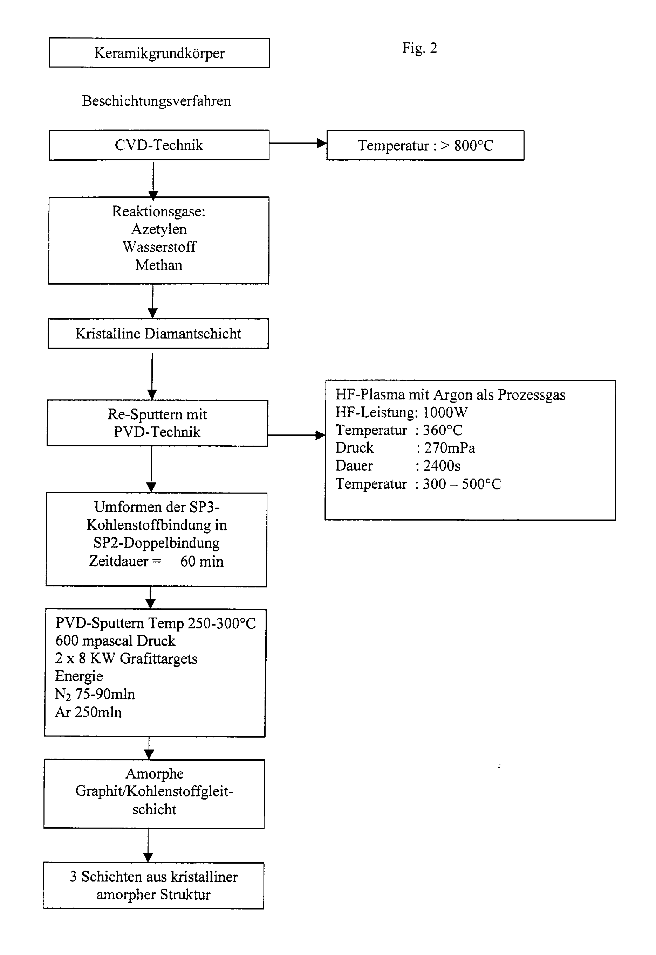

In Figur 2 sind die einzelnen Verfahrensschritte zur Herstellung eines erfindungsgemäßen Schneidwerkzeugs schematisch dargestellt. Die im CVD-Verfahren hergestellte kristalline Diamantschicht wird unter üblichen Bedingungen im Hot-Filament-CVD-Prinzip durchgeführt, wobei als Prozessgase Wasserstoff und Methan über einen heißen Glühdraht bei 2000°C geleitet werden. Die Prozessgase werden dabei thermisch aktiviert, wodurch große Mengen an atomarem Kohlenstoff freigesetzt und auf dem gegenüberliegenden Substrat als feinkristalliner Diamantfilm abgeschieden werden.

Anschließend wird ein Re-Sputtern der obersten Randzone der Diamantschicht mit PVD-Technik bei 200-250°C in Argonatmosphäre durchgeführt. Dabei wird die kristalline Anordnung der Kohlenstoffatome gestört durch Beschuß mit hochenergetischen Argon-Ionen. Durch Impulsübertragung beim Aufschlagen der ArgonIonen werden die sp3-Bindungen gesprengt und die Kohlenstoffatome ordnen sich um. Zum Teil kondensieren die herausgeschlagenen Kohlenstoffatome wieder in den während des Re-Sputterns gebildeten atomaren Lücken, so dass eine dünne Schicht mit sp2-gebundenen Kohlenstoff entsteht. Da diese amorphisierte Diamantoberflächenschicht dem Aufbau der nachfolgend abgeschiedenen elastischen Kohlenstoffschicht aus amorphen graphit- und diamant- ähnlichen Bestandteilen sehr nahekommt, bildet sie eine ausgezeichnete Grundlage für die chemische Anbindung dieser Schicht. Es tritt somit ein inniges Verwachsen der Diamantschicht mit der Dämpfungsschicht auf.

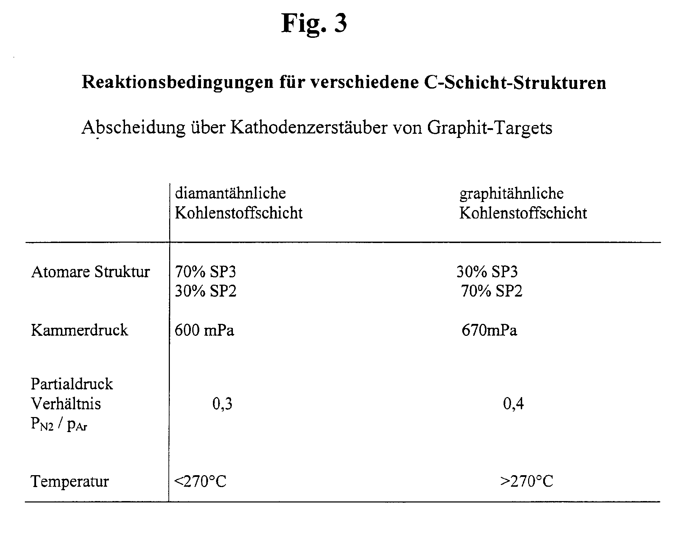

Die zähere, weichere Dämpfungsschicht wird im PVD-Verfahren durch Sputtern von Kohlenstofftargets abgeschieden. Die Temperatur variiert zwischen 250 und 300°C ebenso wie der Stickstoffanteil (Fig. 3) je nachdem ob die Schicht graphit- oder diamantähnlicher ausgebildet wird. Die Einsatztemperatur der Schicht liegt bei 450°C und der Reibwert zwischen 0,1 und 0,3.

Durch die amorphe Kohlenstoffschicht 3 werden die Rauhigkeitsspitzen auf der Oberfläche der Diamantschicht 2 elastisch abgefedert und infolge der verbesserten Spanabfuhr für eine besonders günstige Wärmeableitung aus der Schneidzone gesorgt.

In einem bevorzugten Anwendungsfall der vorliegenden Erfindung werden die Nebenschneiden und Spannuten des diamantbeschichteten Hartmetall-Schneidwerkzeuges mit amorphem graphitisierten Kohlenstoff beschichtet. Hierdurch werden Staueffekte beim Abgleiten der bei der Zerspanung entstehenden Pulverpartikel vermindert. Der amorphe Kohlenstoff wirkt quasi als Aufprallfläche und Trockenschmiermittel und ermöglicht das ungehinderte Herausgleiten der Späne. Damit kann eine Vergrößerung des Vorschubs beim Zerspanen von Graphit- oder Grünlings-Körpern bei gleichzeitig verlängerter Standzeit um ca. 30% erfolgen.

Vergleichstest zur Standzeitbeurteilung

Einsatzparameter:

| Graphitsorte | Feinkorn - Korngröße 3 - 5 µm | |
|---|---|---|
| Fräserdurchmesser | 8 mm | |
| Schnittgeschwindigkeit | Vc = 450 $^m$/min | ac =16mm |
| Vorschubgeschwindigkeit | f = 2500 $^m$/min | ap = 8mm |

Beurteilungskriterium für Standzeiten: Verschleißmarkenbreite 0,1

| | Standzeit oder Standweg |
|---|---|
| Erfindungsgemäßes Werkzeug (DIP) | 128m |
| Diamantbeschichtetes Werkzeug | 100m |

Als weiterer Vergleichstest zur Schichthaftungsprüfung dient der Ritztest. Dabei wurde die kritische Last ermittelt, bei der die ersten Abplatzungen der Kohlenstoffschicht auftraten. Sie wurde als Maß für den Zusammenhalt des Werkstoffverbundes Kohlenstoffschicht/Diamantschicht herangezogen. Die kritischen Lasten lagen für die über die Chemiesorptionsschicht an den Diamant gebundene Kohlenstoffschicht bei 10,8N gegenüber 2,7N für Schichten, die ohne dem Zwischenschritt des Re-Sputterns hergestellt wurden. Demzufolge konnte der Zusammenhalt der Schichten durch das neue Verfahren wesentlich verbessert werden, was in einer höheren Zähigkeit der Gesamtschicht resultiert.

**Patentansprüche**

1. Diamantbeschichtetes Hartmetall-Schneidwerkzeug, bestehend aus einer auf einem Substrat aufgetragenen Diamantschicht (2), die ein geschlossenes Grundprofil bildet, und einer darauf abgeschiedenen Kohlenstoffschicht (3),
**dadurch gekennzeichnet,**
**daß** die Diamantschicht (2) polykristallin ist, wobei die Diamantkristalle statistisch orientiert sind, und dass die Kohlenstoffschicht (3) eine amorphe Struktur mit einem Anteil an kovalenten sp3-Bindungen der Kohlenstoffatome von weniger als 70% aufweist.

2. Diamantbeschichtetes Hartmetall-Schneidwerkzeug nach Anspruch 1,
**dadurch gekennzeichnet,**

**daß** die Diamantkristalle der obersten Lage der statistisch orientierten Diamantschicht bei einer Gesamtdicke der Schicht von 2 bis 10μm mindestens 0,5 μm über das Grundprofil (6) hinausragen und die Kohlenstoffschicht einen mehrlagigen Aufbau mit sp2/sp3-gebundenen Kohlenstoffatomen und dazwischen Stickstoffatomen bei einer Gesamt-Dicke von 1 bis 3 μm aufweist.

3. Diamantbeschichtetes Hartmetall- Schneidwerkzeug nach einem der vorhergehenden Ansprüche,
   **dadurch gekennzeichnet,**
   **daß** die amorphe Kohlenstoffschicht mit der Diamantschicht über eine als Chemisorptionsschicht ausgebildete Randzone der Diamantkristalle (7) chemisch gebunden ist, wobei eine wechselseitige Elektronenpaarbindung voliegt.

4. Diamantbeschichtetes Hartmetall- Schneidwerkzeug nach einem der vorhergehenden Ansprüche,
   **dadurch gekennzeichnet,**
   **daß** die Atome in einer Umwandlungzone im Randbereich der Diamantschicht (7) zu mindestens 70% in sp2-Bindungen angeordnet sind.

5. Diamantbeschichtetes Hartmetall-Schneidwerkzeug nach einem der vorhergehenden Ansprüche,
   **dadurch gekennzeichnet,**
   **daß** die Belastbarkeit des Werkstoffverbundes aus Diamant- und Kohlenstoffschicht, ausgedrückt durch den Kennwert Lc (kritische Last), gemessen im Scratch-Test), unter Einschluss einer dazwischengeschalteten Chemiesorptionsschicht um mehr als das dreifache erhöht ist als ohne Chemiesorptionsschicht.

6. Verfahren zur Herstellung eines diamantbeschichteten Hartmetall-Schneidwerkzeuges nach einem der vorhergehenden Ansprüche,
   **dadurch gekennzeichnet,**
   **daß** der Hartmetallgrundkörper (1) mit einer kristallinen Diamantschicht (2) im CVD-Verfahren bei Temperaturen über 800°C beschichtet wird, dann ein PVD-Re-Sputtern der über das Grundprofil hinausragenden Diamantkristalle mit einer Änderung der SP3-Diamantbeschichtung zu SP2-Doppelbindungen erfolgt und danach eine Kohlenstoffbeschichtung im PVD-Verfahren bei einer Temperatur von weniger als 500°C durchgeführt wird, wobei die Kohlenstoffschicht durch Zugabe eines Reaktivgases in einer amorphen Struktur ausgebildet wird.

7. Verfahren nach Anspruch 6,
   **dadurch gekennzeichnet,**
   **daß** die Kohlenstoffbindung in der Randzone der polykristallinen Diamantschicht durch Re-Sputtern bei Temperaturen zwischen 300-400°C, durch eine Umordnung der Atome, von der sp3-Bindung in eine sp2-Bindung umgebaut wird und danach durch PVD-Sputtern von Graphit-Targets bei Temperaturen von 250-300°C eine amorphe Kohlenstoffschicht ausgebildet wird.

# Prinzipielle Darstellung des erfindungsgemäßen Schichtaufbaus

I. Mikroskopischer Bereich

Maßstab 1:20000

II. Submikroskopischer/Atomarer Bereich

Maßstab 1:1400000

Fig. 1

EP 1 182 274 A1

| Keramikgrundkörper |

Fig. 2

Beschichtungsverfahren

| CVD-Technik | → | Temperatur : > 800°C |

↓

| Reaktionsgase:<br>Azetylen<br>Wasserstoff<br>Methan |

↓

| Kristalline Diamantschicht |

↓

| Re-Sputtern mit<br>PVD-Technik | → | HF-Plasma mit Argon als Prozessgas<br>HF-Leistung: 1000W<br>Temperatur  : 360°C<br>Druck         : 270mPa<br>Dauer         : 2400s<br>Temperatur  : 300 – 500°C |

↓

| Umformen der SP3-<br>Kohlenstoffbindung in<br>SP2-Doppelbindung<br>Zeitdauer =    60 min |

↓

| PVD-Sputtern Temp 250-300°C<br>600 mpascal Druck<br>2 x 8 KW Grafittargets<br>Energie<br>$N_2$ 75-90mln<br>Ar 250mln |

↓

| Amorphe<br>Graphit/Kohlenstoffgleit-<br>schicht |

↓

| 3 Schichten aus kristalliner<br>amorpher Struktur |

7

# Fig. 3

## Reaktionsbedingungen für verschiedene C-Schicht-Strukturen

Abscheidung über Kathodenzerstäuber von Graphit-Targets

|  | diamantähnliche Kohlenstoffschicht | graphitähnliche Kohlenstoffschicht |
|---|---|---|
| Atomare Struktur | 70% SP3 30% SP2 | 30% SP3 70% SP2 |
| Kammerdruck | 600 mPa | 670mPa |
| Partialdruck Verhältnis $P_{N2}$ / $p_{Ar}$ | 0,3 | 0,4 |
| Temperatur | <270°C | >270°C |

**Europäisches Patentamt**

## EUROPÄISCHER RECHERCHENBERICHT

Nummer der Anmeldung

EP 01 12 0344

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| Y | US 6 066 399 A (DOMOTO YOICHI ET AL) 23. Mai 2000 (2000-05-23) | 1 | C23C16/26 C23C16/27 |
| A | * Spalte 2, Zeile 42 – Zeile 57 * <br> * Spalte 9, Zeile 24 – Zeile 60 * <br> * Spalte 14, Zeile 38 – Zeile 45 * | 2–7 | |
| Y | US 5 310 596 A (CANN GORDON L ET AL) 10. Mai 1994 (1994-05-10) | 1 | |
| A | * das ganze Dokument * | 2–7 | |
| A | PATENT ABSTRACTS OF JAPAN vol. 013, no. 419 (C-637), 18. September 1989 (1989-09-18) & JP 01 157412 A (NIPPON SOKEN INC), 20. Juni 1989 (1989-06-20) * Zusammenfassung * | 1–7 | |
| A,D | DE 198 50 346 A (FRAUNHOFER GES FORSCHUNG) 4. Mai 2000 (2000-05-04) * Ansprüche 1-6 * | 1–7 | |

**RECHERCHIERTE SACHGEBIETE (Int.Cl.7)**

C23C

Der vorliegende Recherchenbericht wurde für alle Patentansprüche erstellt

| Recherchenort | Abschlußdatum der Recherche | Prüfer |
|---|---|---|
| DEN HAAG | 28. November 2001 | Ekhult, H |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

**ANHANG ZUM EUROPÄISCHEN RECHERCHENBERICHT
ÜBER DIE EUROPÄISCHE PATENTANMELDUNG NR.**   EP 01 12 0344

In diesem Anhang sind die Mitglieder der Patentfamilien der im obengenannten europäischen Recherchenbericht angeführten
Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

28-11-2001

| Im Recherchenbericht angeführtes Patentdokument | | Datum der Veröffentlichung | Mitglied(er) der Patentfamilie | | Datum der Veröffentlichung |
|---|---|---|---|---|---|
| US 6066399 | A | 23-05-2000 | JP | 10259482 A | 29-09-1998 |
|  |  |  | JP | 10259481 A | 29-09-1998 |
|  |  |  | JP | 11100294 A | 13-04-1999 |
| US 5310596 | A | 10-05-1994 | US | 5518766 A | 21-05-1996 |
|  |  |  | CA | 2044543 A1 | 11-02-1992 |
|  |  |  | DE | 69131063 D1 | 06-05-1999 |
|  |  |  | DE | 69131063 T2 | 18-11-1999 |
|  |  |  | EP | 0470644 A2 | 12-02-1992 |
|  |  |  | EP | 0909835 A1 | 21-04-1999 |
|  |  |  | JP | 4232273 A | 20-08-1992 |
| JP 01157412 | A | 20-06-1989 | JP | 2679067 B2 | 19-11-1997 |
| DE 19850346 | A | 04-05-2000 | DE | 19850346 A1 | 04-05-2000 |
|  |  |  | WO | 0026433 A2 | 11-05-2000 |
|  |  |  | EP | 1144719 A2 | 17-10-2001 |

Für nähere Einzelheiten zu diesem Anhang : siehe Amtsblatt des Europäischen Patentamts, Nr.12/82